# EUROPEAN PATENT APPLICATION

(11) **EP 1 569 265 A2**
(43) Date of publication of application: **31.08.2005**
(21) Application number: 05007943.3
(22) Date of filing: 03.08.1995
(51) Int. Cl.: H01L 21/265, H01L 21/3065, H01L 21/308, H01L 21/8242

(54) **Semiconductor device having trenches and method of forming trenches**

(30) Priority: 03.08.1994 US 283162
(62) Divisional of application: 95112234.0
(71) Applicant: KABUSHIKI KAISHA TOSHIBA, Tokyo (JP)
(72) Inventor: Tsuchiaki, Masakatsu, Minato-ku Tokyo 105 (JP)
(74) Representative: HOFFMANN EITLE

(57) **Abstract**

Trenches (51 to 57) having different profiles are formed in a material, such as a semiconductor substrate (10), by forming resist pattern having windows (31 to 37) with at least two different widths. An etchant, such as Fluorine, is implanted into portions of the semiconductor using an ion implantation technique. A tilt angle and an azimuth angle of the ion beam are chosen such that the Fluorine ions cannot pass through narrower resist windows (31 to 35) but can pass through wider resist windows (36, 37) to impinge on the underlying semiconductor substrate (10). The semiconductor substrate (10) is then subjected to an anisotropic etching process. Accordingly, the substrate regions exposed between the narrow-width resist windows are etched to produce trenches (51 to 55) having highly vertical profiles. The substrate regions exposed by the wide-width resist windows, including the regions having implanted etchant ions, are preferentially etched to produce trenches (56, 57) having tapered profiles.

## Description

The present invention relates to a semiconductor device having semiconductor elements isolated by trenches of different profiles, and also to a method of manufacturing the semiconductor device.

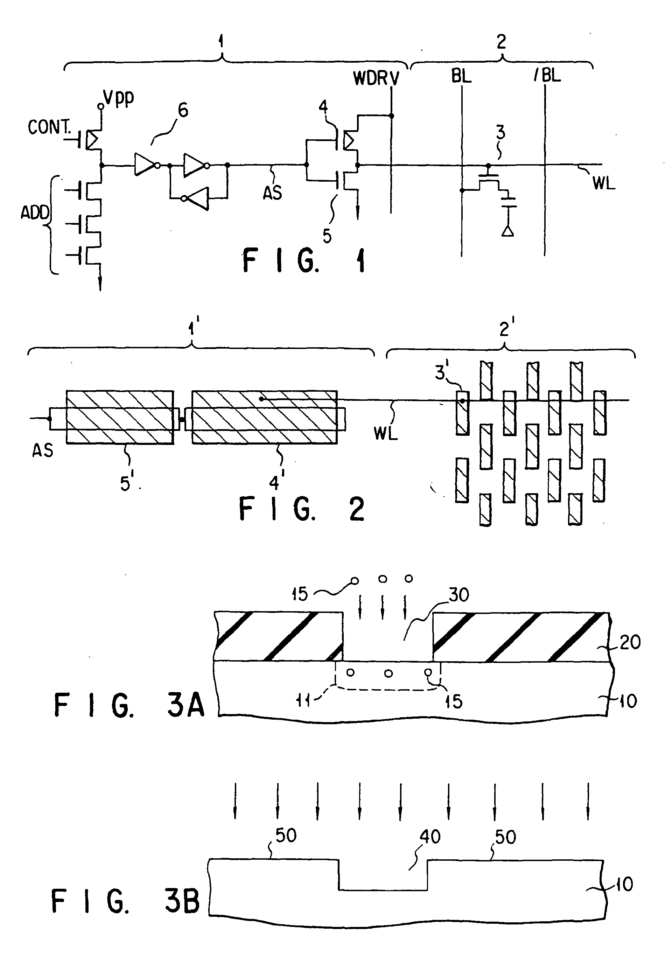

The discrete circuits of an integrated circuit chip can be isolated from one another using shallow trenches formed in the semiconductor substrate. This technique is appropriately known as shallow trench isolation (STI). Many semiconductor chips have semiconductor devices of various sizes. In these semiconductor chips, the same sized semiconductor devices often are organized in distinct regions. For example, dynamic random access memory (DRAM) chips include array regions comprising relatively small memory cells and peripheral regions comprising relatively large devices, such as decoder circuitry and other peripheral circuitry. FIG. 1 provides a circuit diagram that illustrates this arrangement. As shown in FIG. 1, a conventional DRAM includes a peripheral circuit region 1 and a memory cell array region 2.

The memory cell array region 2 includes memory cells formed at the intersections of word lines and bit lines. For convenience, only memory cell 3 formed at the intersection of a word line WL and bit lines BL and /BL is shown. The peripheral circuit region 1 includes various peripheral circuit elements for selecting memory cells, including memory cell 3, coupled to word line WL. For example, the peripheral circuit region 1 includes a p-channel field effect transistor (FET) 4 and an n-channel FET 5. The control gates of FETs 4 and 5 are each connected to selection circuitry 6. A first terminal of each of the FETs are connected in common to word line WL. A second terminal of the p-channel FET 4 receives a word line drive signal WDRV. A second terminal of the n-channel FET 5 is coupled to ground.

FIG. 2 illustrates a plan view of the DRAM of FIG. 1 with associated resist patterns 1' and 2' for forming peripheral circuit region 1 and memory cell array region 2, respectively. The resist pattern 2' corresponding to the memory cell array region 2 includes a plurality of relatively small individual resist areas, including individual resist area 3' corresponding to memory cell 3. Resist pattern 1', corresponding to the peripheral circuit region 1, has relatively large individual resist areas 4' and 5' corresponding to FETs 4 and 5, respectively. The large individual resist areas of resist pattern 1' are spaced further apart than the small individual resist areas of resist pattern 2'. Accordingly, relatively large peripheral circuit elements can be formed in peripheral circuit region 1 and relatively small memory cells can be formed in memory cell array region 2.

Several problems arise when different sized devices formed in a single semiconductor chip are isolated using trenches. For example, power dissipation may unduly limit circuit performance. A semiconductor element, for example a field-effect transistor (FET), may be formed in a region (hereinafter referred to as "element region") isolated by a trench from any other region. If the trench is substantially vertical to the semiconductor substrate, the element region is shaped like an island, having a sharp corner at an edge. A channel region of the FET is formed in the element region. A part of the channel region is located in the sharp corner of the element region. The trench is filled with insulating material which has a dielectric constant smaller than that of the semiconductor substrate. Therefore, the corner of the element region has a sharp boundary which is not electrodynamically uniform. The field effect the gate electrode imposes on the central part of the channel region greatly differs from the field effect it imposes on the sharp corner of the element region. An inversion layer is formed in the sharp corner at a lower gate voltage than in the central part of the channel region. This means a parasitic transistor having a low threshold voltage is unexpectedly formed in the sharp corner of the element region. In other words, the FET inevitably has two or more threshold voltages. Formed in an element region isolated by a vertical trench, the FET cannot be designed by ordinary method. If a low voltage is applied, by accident, to the gate electrode, an inversion layer will develop along the sharp corner, and a leakage current will flow. The operating current cannot be effectively cut off in the FET.

A peripheral circuit of, for example, a DRAM is a large device which is driven by a relatively large current. Assume this device has an FET having a sharp corner. Then, a great leakage current flows in the FET. The leakage current results in a power loss in the chip, ultimately reducing the operating efficiency of the device. The more obtuse the angle of the corner, the less the threshold voltage drop occurring in the corner of the FET, and the smaller the difference between the threshold voltage at the corner of the FET and the threshold voltage at the central part of the channel region. In other words, the greater the angle of the corner, less likely the threshold voltage will drop at the corner. Hence, the FET must be isolated from any other element by a trench having such a profile as increases the angle of the corner, so that the leakage current may be reduced to minimize the power loss in the large device.

By contrast, memory cells forming an array are small devices arranged very close to one another. If any two adjacent memory cells are isolated by a trench having a corner of an obtuse angle, the trench must be shallow since the distance between the memory cells is short. Consequently, the memory cells are electrically isolated as much as desired. In a DRAM, the memory cells may assume wrong positions if patterning errors are made while the DRAM is being manufactured. If this is the case, the memory cells cannot be isolated by deep trenches as designed.

The channel region of a small device is proportionally small. Both the central part and the corner part of the channel region are therefore so small that they have almost the same threshold voltage. The threshold voltage of the small device does not depend on the shape of the corner. Rather, it depends on almost only the shape of the depletion layer. Hence, a small device can operate as a FET having a threshold voltage even if isolated from another small device by a trench which is substantially vertical. Thus, it is desirable that small devices be isolated by vertical trenches, so that they may be arranged in high density.

Devices of different sizes formed in the same semiconductor chip may be isolated by trenches. In order to impart good electrical characteristics to the devices, it is desirable that each trench have a different profile in accordance with the sizes of the devices which it isolates. To form trenches of different profiles, however, special steps need to be performed. For example, a vertical trench must be formed in an etching step to isolate small devices, and a tapered trench must be formed in another etching to isolate large devices. Each etching step requires an etching mask which is formed by lithography. It would take much time and cost to form trenches having different profiles.

The present invention has been made to solve the problems described above. The object of the invention is to provide a device and a method of forming in the same semiconductor chip a vertical trench to isolate small devices and a tapered trench to isolate large devices, by a relatively simple process and, hence, at low cost.

According to the present invention, there is provided a semiconductor device comprising: a semiconductor substrate; a first transistor provided in the semiconductor substrate and having a channel region of a small size, the first transistor being isolated from other regions by vertical trenches; and a second transistor provided in the semiconductor substrate and having a channel region of a large size, the second transistor being isolated from the other regions by tapered trenches.

Since the vertical trenches isolate the sides of the small channel region of the first transistor from the other regions, the first transistor can be arranged with high precision. Since the tapered trenches isolate the sides of the large channel region of the second transistor from the other regions, the leakage current can be reduced in the second transistor, to minimize the power loss.

According to the present invention, trenches having different profiles are formed in a material, for example, a semiconductor substrate. A resist pattern or other mask material pattern having first and second windows is formed on the material. The width of the second window is greater than that of the first window. The resist pattern and material are subjected to ion bombardment using ions of an etchant, such as Fluorine, or a non-etchant, such as Argon. The ions are directed at the resist pattern and material at predetermined angles with respect to the surface normal and standard azimuth direction of the material. The predetermined angles are selected such that the ions impinge on the material through the wider second window but do not reach the material through the narrower first window.

The surface of the material and the resist pattern are then subjected to an etching step, for example, an anisotropic reactive ion etching step, to form first and second trenches corresponding to the first and second windows, respectively. The material exposed by the first window, which was not subject to ion bombardment, is etched away to form the first trench with a substantially vertical profile. The material exposed by the second window and subject to ion bombardment is etched away to form the second trench having a substantially tapered profile. The etching step proceeds preferentially in the region of the second window due to the impact of the ion bombardment and the chemical effect of the implanted ions, if etchants.

Accordingly, the present invention enables the formation of trenches having different profiles in a single etching step. Further, by adjusting parameters such as window width, the angles of incidence of the ions, and the energy of the ions, for example, the slope of the second trench may be easily controlled. The present invention may be utilized to form substantially vertical trenches in an array region of a semiconductor memory device, such as a DRAM, and to form substantially tapered trenches in a peripheral region of the memory device. Thus, substantially vertical trenches can be used to isolate memory cells to facilitate alignment and substantially tapered trenches can be used to isolate peripheral devices to suppress power dissipation.

With the method according to the present invention it is possible to form vertical trenches and tapered trenches in the same semiconductor chip, thereby to isolate small devices provided in the semiconductor chip. The trenches can be formed easily, ultimately reducing the manufacturing cost of an integrated circuit.

This invention can be more fully understood from the following detailed description when taken in conjunction with the accompanying drawings, in which:
A more complete appreciation of the present invention and many of the attendant advantages thereof will be readily obtained as the invention becomes better understood by reference to the following detailed description when considered in connection with the accompanying drawings.
FIG. 1 illustrates conventional circuitry in a dynamic random access memory (DRAM).
FIG. 2 illustrates a plan view of the DRAM of FIG. 1 with associated resist patterns for a peripheral circuit region and a memory cell array region.
FIGS. 3A and 3B illustrate the general principle of incorporating an etchant and/or non-etchant by ion implantation and etching.
FIG. 4A illustrates a semiconductor substrate.
FIG. 4B illustrates a mask formed on the semiconductor substrate of FIG. 4A.
FIG. 5 illustrates a resist pattern formed on the semiconductor substrate of FIG. 4B.
FIG. 6 illustrates tilt implantation of ions into the semiconductor substrate having thereon a mask pattern with windows of different width.
FIG. 7 illustrates the effects of etching on a semiconductor substrate subject to ion implantation according to FIG. 6.
FIG. 8 shows an expanded view of a semiconductor substrate similar to that of FIGS. 6 and 7 after etching is concluded.
FIG. 9A illustrates a plan view of a resist pattern formed in a memory cell array region 10A of a memory device.
FIG. 9B illustrates a plan view of a resist pattern formed in a peripheral circuit region 10B of a memory device.
FIG. 10 illustrates a plan view of ions directed at semiconductor substrate at an azimuth angle *β*.
FIG. 11 is a perspective view of a dynamic random-access memory according to the present invention;
FIG. 12 is a perspective view of the dynamic random-access memory, partly sectional, taken along line 12-12 shown in FIG. 11;
FIG. 13 is a perspective view of the dynamic random-access memory, partly sectional, taken along line 13-13 shown in FIG. 11;
FIG. 14 is a circuit diagram showing a static random-access memory according to the invention; and
FIGS. 15A, 15B and 15C are diagrams illustrating a gate array circuit according to this invention.

The general principles of the invention will be discussed in connection with FIGS. 3A and 3B. A resist pattern 20 is formed on a semiconductor substrate 10 according to well known methods, for example, lithography. However, the present invention is not limited to resist as a masking material. While the invention will be described using resist as the masking material for convenience, it should be understood that any other mask material may be used consistent with the present invention. The resist pattern 20 includes a window 30 to the semiconductor substrate 10. An etchant material 15, such as Fluorine, is incorporated into the semiconductor substrate 10, for example, by ion implantation through window 30. It should be understood that the present invention is not limited to the use of Fluorine as an etchant. Other etchants, such as Chlorine, may also be used. Alternatively, non-etchants such as Argon, for example, may be implanted. Further, a combination of etchants and non-etchants may be used in a single implantation step or in plural implantation steps.

Next, the semiconductor substrate 10 is exposed to plasma atmosphere. Prior to this step the resist pattern 20 may be removed. The plasma may contain an etching gas such as fluorine or chlorine. In this case, the substrate 10 is etched by sputter-etching mechanism using positive ions applied from the plasma onto the substrate 10. Alternatively, the substrate 10 may be etched by chemical reaction between itself and an etching gas reinforced by ions, such as ion-reinforced etching gas or ion-assisted etching gas. Ions may be applied to the substrate 10, either by exposing the substrate 10 to the plasma atmosphere or by applying ion beams to the substrate 10.

The ion implantation step ensures preferential etching of the ion implanted regions. Bombardment by etchant or non-etchant ions causes physical damage to the substrate. The damaged substrate regions etch at a greater rate than undamaged substrate regions. Thus, implantation of a non-etchant serves to speed the etching rate by physically damaging the impact region. Further, if an etchant is implanted, the etchant serves to break chemical bonds in the substrate. Accordingly, the implanted etchant speeds the etching rate by both physical and chemical mechanisms.

As a result, the selective etching proceeds or is accelerated at the ion-implanted region 11. A trench 40 is thereby formed in the region 11 as illustrated in FIG. 3B.

A method of forming a trench having a profile determined by the sizes of the devices the trench is to isolate will be explained below.

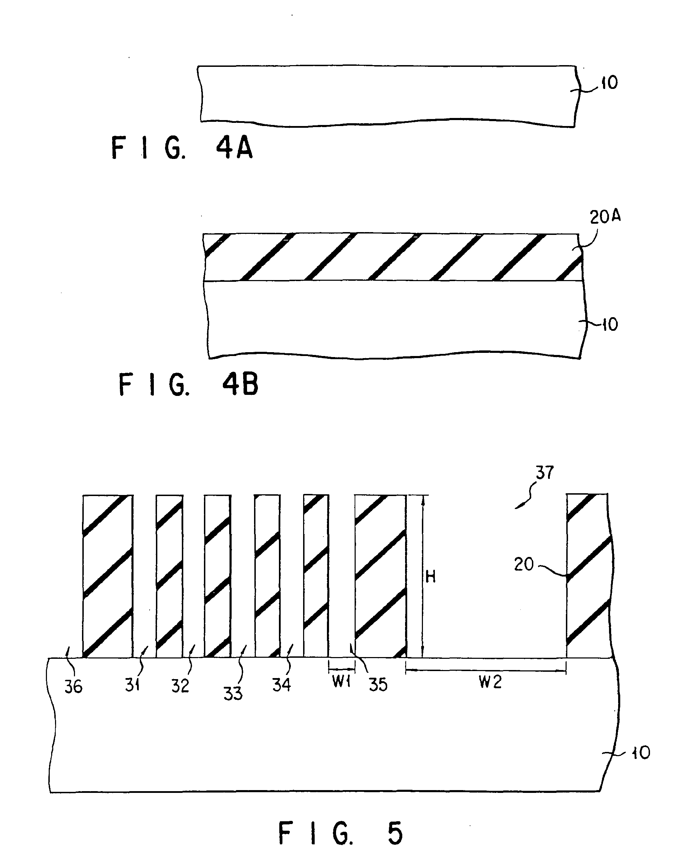

FIG. 4A shows a substrate 10, for example, silicon, to be processed according to the present invention. Of course, other semiconductor substrates or other materials may be used in accordance with the present invention. Further, the semiconductor substrate 10 may comprise a plurality of layers of different materials, for example, silicon nitride on a silicon substrate. For convenience, element 10 will be referred to as semiconductor substrate 10.

As shown in FIG. 4B, a resist film 20A is formed on the semiconductor substrate 10. As noted above mask materials other than resist may be used consistent with the present invention. The resist film 20A is subjected to known photolithography techniques to form a resist pattern 20 as illustrated in FIG. 5. As shown in FIG. 5, the resist pattern 20 includes a plurality of windows 31-37 that expose a surface of the semiconductor substrate 10. Of course, resist pattern 20 is intended to illustrated the principles of the present invention, and should not be construed to limit the invention. The resist pattern 20 has a height H, which may be, for example, 0.95 *µ*m. As can be seen, windows 31-35 have a first width W1, and windows 36 and 37 have a second width W2, where W2 > W1. For example, W1 may be about 0.25 *µ*m and W2 may be about 10 *µ*m. Of course, the arrangement shown in FIG. 5 is intended to be illustrative and should not be considered to limit the present invention. For example, the resist height H may be varied, and any number of windows having any window width W may be provided consistent with the present invention.

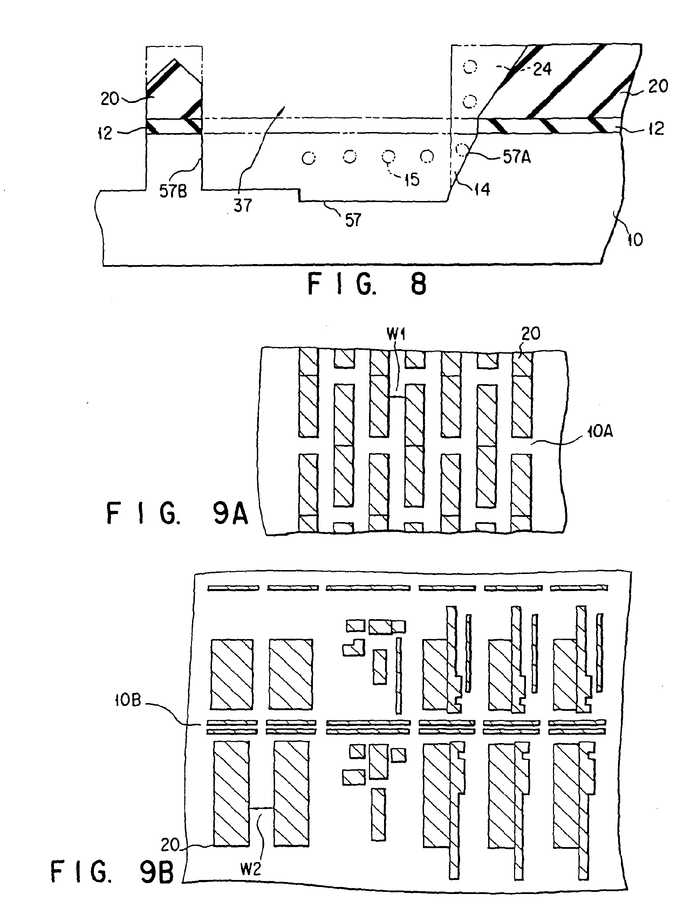

In general, windows 31-35 may be formed in a first region of semiconductor substrate 10 where it is desired to have trenches having a first characteristic trench profile, and windows 36 and 37 may be formed in a second region of a semiconductor substrate 10 where it is desired to have trenches having a second characteristic trench profile. For example, as illustrated in FIG. 9A, the first region may correspond to a memory cell array region 10A of a memory device, such as a DRAM, where relatively small memory cell devices are formed and where trenches having substantially vertical profiles are required to ensure a precise alignment. The memory cell array region 10A includes a resist pattern 20 including windows having the first width W1. Accordingly, vertical trenches may be formed in the memory cell array region 10A.

As illustrated in FIG. 9B, the second region may correspond to a peripheral circuit region 10B of the memory cell device, such as a DRAM, where relatively large peripheral circuits are formed and where trenches having substantially tapered trench profiles are required to minimize leakage currents and resulting power dissipation. The peripheral circuit region 10B includes a resist pattern 20 including windows having the second width W2. Thus, tapered trenches may be formed in the peripheral circuit region 10B.

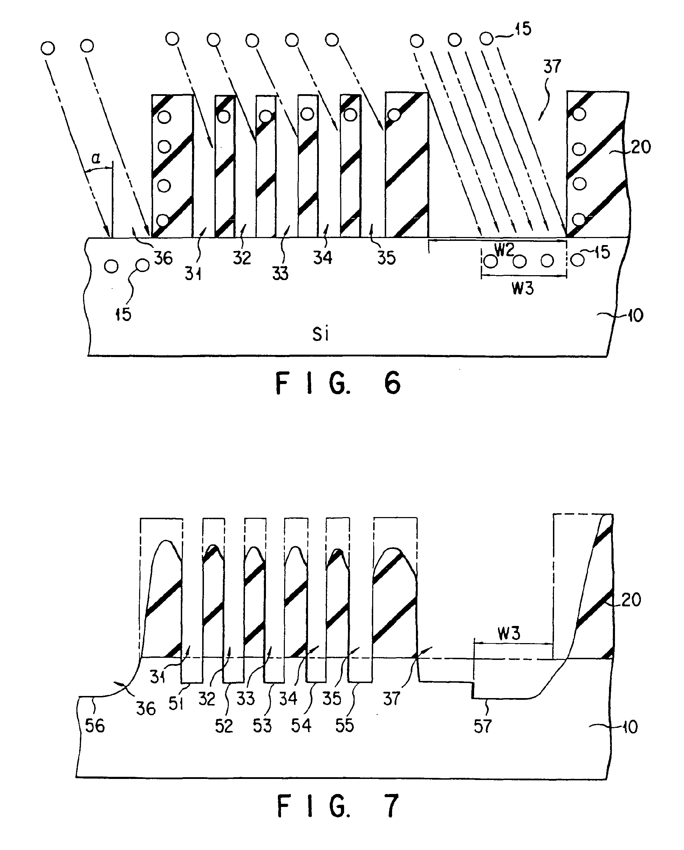

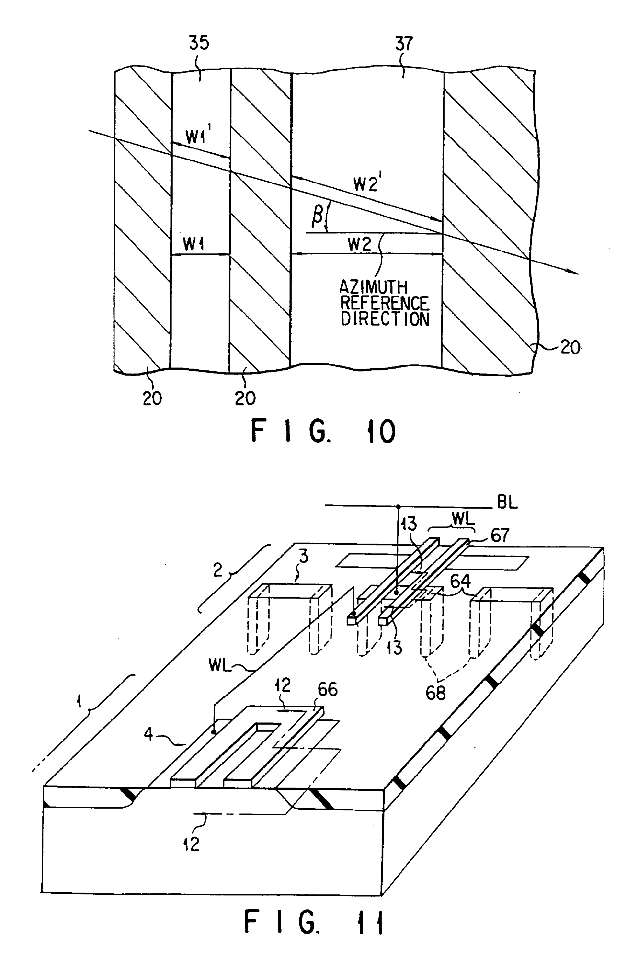

After formation of the resist pattern 20, the semiconductor substrate 10 is subjected to a tilt ion implantation procedure, as illustrated in FIG. 6, whereby the ions 15 are implanted at a predetermined tilt angle α with respect to the surface normal of the semiconductor substrate 10 and a predetermined azimuth angle β with respect to an azimuth reference direction. FIG. 10 is a plan view of substrate 10 to illustrate the azimuth angle β of the ion beam with respect to an arbitrary azimuth reference direction. The tilt angle α and azimuth angle β may be selected such that the implantation ions pass through windows 36 and 37 to reach the portion W3 of the surface of the semiconductor substrate 10 but do not pass through windows 31-35 to reach to the surface of the semiconductor substrate 10. W3 may be varied in accordance with the tilt angle α, the azimuth angle *β*, and the resist height H.

For example, for a given resist pattern height H and window widths W, an appropriate tilt angle α and azimuth angle β may be selected to produce an implant area W3 in the semiconductor substrate 10, to achieve a desired implant profile and thus a trench having a desired taper profile. The following relation may serve as a guideline for the selection of a tilt angle α and an azimuth angle *β*:
W1' < H tan α < W2'
where: W1' - W1/cos *β*; and
W2' = W2/cos *β*.

Further, the ions can be beamed at a predetermined implantation energy to achieve predetermined depth in the semiconductor substrate 10. Preferably, ion energies of 10 KeV or greater are utilized. In addition, an implantation dose may be selected to achieve a predetermined concentration in the semiconductor substrate 10 where they strike. In general, higher implant concentrations produce greater physical damage and, if the implanted ion is an etchant, greater chemical damage. Thus, the implantation energy and implantation dose of the ions are among the factors which affect the etch rate, and thus the resulting trench profile. Of course, the etch rate also depends on the material etched, the implanted material, and the reactive ion etching process.

As depicted in FIG. 6 for purposes of illustration, ions of the etchant Fluorine are used to bombard the semiconductor substrate 10 and resist pattern 20 at a tilt angle α. The azimuth angle β of the ion beam is aligned with the plane of the page. The Fluorine ions strike the top part of the resist pattern adjacent windows 31-35 but do not reach the semiconductor substrate through windows 31-35. Accordingly, areas of the semiconductor substrate 10 exposed through windows 31-35 are not implanted with ions. The angle α is sufficient to permit the Fluorine ions to strike the semiconductor substrate 10 through windows 36 and 37. The Fluorine ions additionally impinge on the sides of the resist that forms windows 36 and 37. FIG. 6 illustrates the resulting distribution of Fluorine ions implanted ion the substrate 10 and the resist pattern 20 from one direction. Of course, the distribution of implanted ions, and thus the trench profile, can be tailored by implanting ions at several different tilt angles α and/or azimuth angles *β*. Further, the azimuth angle β may be varied with time to effect a rotation implantation.

The semiconductor substrate 10 and the resist pattern 20 are then etched, for example, using a highly anisotropic RIE process. FIG. 7 illustrates the semiconductor substrate according to FIG. 6 after etching. The dotted lines show the outline of the semiconductor substrate 10 and resist pattern 20 before etching. As has been described in conjunction with the basic concept of the invention, an additional etching reaction proceeds in the region implanted with fluorine ions, by virtue of not only the RIE etching but also the physical and chemical effects induced by the fluorine ions. In the ion-implanted region, etching proceeds in not only vertical direction but also horizontal direction. Furthermore, the fluorine implanted into the sides of the resist promotes erosion of the resist mask. As the opening of the resist mask gradually expands, the trenches 56 and 57 being formed beneath the windows 36 and 36 come to have a tapered profile.

In the region into which no fluorine ions have been implanted, only the highly anisotropic RIE proceeds, forming a vertical trench in this region. In those regions of the substrate 10 which lie below the windows 31 to 35 and which fluorine ions have not reached, trenches 51 to 55 are formed which have a vertical profile, though the resist pattern is eroded at its upper portion.

Thus, trenches having a vertical profile are formed in the regions which lie below the windows 31 to 35 and in which relatively small devices are arranged in high density, and trench having a tapered profile are formed in the regions which lie below the windows 36 and 37 and in which relatively large devices are formed.

It should be clear that the particular trench profile produced by the etching step may be precisely tailored to specific requirements by adjusting the ion implant profile. This may be accomplished through careful selection of the relevant parameters affecting implant profile, such as resist height, window width, tilt angle of the ion beam, azimuth angle of the ion beam, energy of the ion beam, and the characteristics of the materials used. For example, a more tapered trench may be produced by increasing the tilt angle and/or the energy of the ion beam. Accordingly, the formation of the taper may be controlled more easily by adjusting the implant profile than by other methods that vary according to etching conditions, etching area, chamber seasoning and the like which tend to be restrict etching parameters and options.

FIG. 8 provides a more detailed view of region similar to that surrounding window 37 of FIG. 7 after etching is concluded. In this case a nitride layer (e.g., SiN) 12 is formed on the surface of the semiconductor substrate 10 prior to forming the resist pattern 20. The structure of the semiconductor substrate 10, the nitride layer 12, and the resist pattern 20 after ion implantation and before etching are shown with dotted lines.

As illustrated, a lateral portion 14 of the semiconductor substrate 10 and a lateral portion 24 of the resist pattern 20 are implanted with Fluorine ions 15 during the tilt implantation phase. Consequently, lateral etching causes lateral portion 14 to be etched during the etching phase. In addition, resist or mask regression is manifest by lateral portion 24 being etched away during the etching phase. Because the resist pattern 20 is generally softer than semiconductor substrate 10, it is etched at a greater rate. Moreover, once an oblique surface is formed in the resist, the surface will be etched at an even greater rate due to the higher sputtering yield of ions at an oblique angle. Thus, lateral portion 24 is etched to a greater extent than lateral portion 14.

The removal of lateral portion 14 through etching forms tapered portion 57A of tapered trench 57. Tapered trench 57 does not produce the sharp corners at its drop off as does a vertical trench. Accordingly, tapered trench 57 is suitable for isolating a peripheral circuit, such as a decoder, without significant power dissipation due to electrical field irregularities. However, tapered trench 57 additionally includes a vertical portion 57B opposite the tapered portion 57A. The semiconductor substrate 10 near vertical portion 57B is not implanted with ions during the ion implantation phase as it is shielded by resist pattern 20. Of course, a second ion implantation phase can be performed where the ion beam angle is adjusted to cause tapered trench 57 to have a tapered portion opposite tapered portion 57A. This may be accomplished, for example, by using an ion beam angle with respect to the substrate equal to -α.

In addition, a second ion implantation phase can be implemented. One or more of the parameters of the first implantation phase may be varied in the second implantation to more precisely control the implant profile. For example, the second implantation phase may have a different tilt angle α, a different azimuth angle *β*, different implant energy, produce a different concentration, and/or include a different implant ion. In this way, the implant profile may be further controlled to produce the desired tapered trench. Alternatively, one or more of such parameters may be varied in a single process step. In any event, the trenches may then be filled according to any of a variety of procedures not important in the context of the present invention.

The invention is described above in connection with a semiconductor substrate. It should be understood that the present invention may be used to form trenches in material other than a semiconductor substrate or in material including layers on a semiconductor substrate. Further, it should be clear that a particular ion implant angle α may be effected by controlling the direction of the ion beam, by tilting the semiconductor substrate 10, or both.

FIGS. 11 to 13 shows a DRAM manufactured by the methods described above. The components of the DRAM, which are identical to those shown in FIGS. 1 and 2 will be designated at the same reference numerals in FIGS. 11 to 13.

As shown in FIGS. 11 to 13, transistors 3 constitute memory cells, and transistors 4 (only one shown) are provided in a peripheral circuit region 1. Provided in the region 1 is, for example, a word-line driving circuit. Being an element of the word-line driving circuit, each transistor 4 must be driven by a large current and is therefore made larger than the transistors 3.

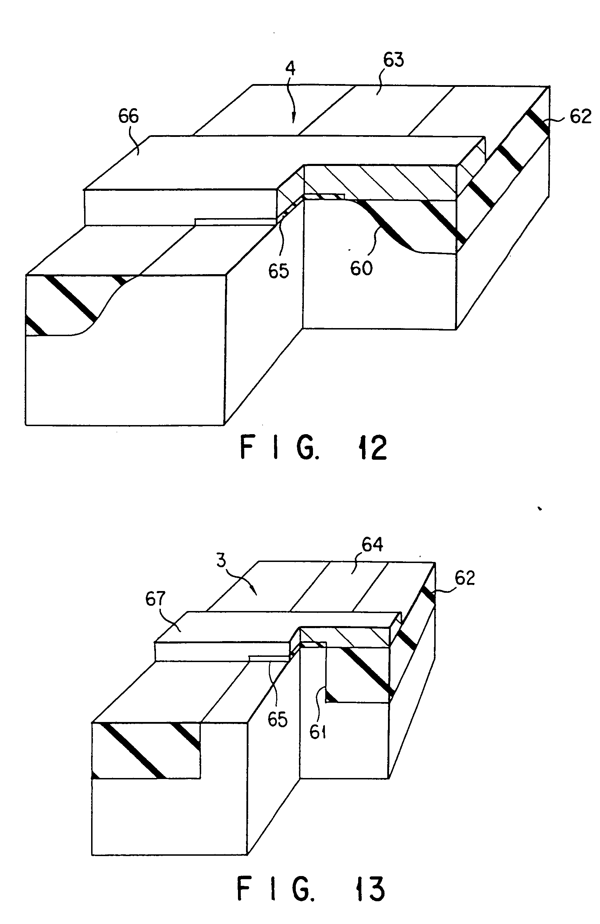

As illustrated in FIG. 12, each transistor 4 is isolated from other transistors by trenches 60 which have two tapered sides each. As shown in FIG. 13, the transistor 3 are isolated from one another by trenches 61 which have two vertical sides each. Formed in the trenches 60 and 61 are silicon oxide films 62. A gate insulating oxide film 65 is provided on element regions 63 and 64. Two gate electrodes 66 and 67 are formed on the oxide film 65 and located respectively above the element regions 63 and 64. The element region 63 has a source (not shown) and a drain (not shown), which are arranged on the sides of the gate electrode 66. Similarly, the element region 64 has a source (not shown) and a drain (not shown), which are arranged on the sides of the gate electrode 67. As shown in FIG. 11, the element region 64 having the transistors 3 has a trench 68 provided for forming a capacitor.

As described above, the transistors 4 made larger than the transistors 3 are isolated from one another by the tapered trenches 60. The tapered trenches 60 reliably cut off the operating current of the transistors 4 since the threshold voltage at their corners does not fall at all. In other words, the tapered trenches 60 reduce the leakage current, minimizing the power loss in the transistors 4.

As described above, the small transistors 3 are isolated from one another by the vertical trenches 61. They can therefore be arranged with high precision, without sacrificing their operating characteristics.

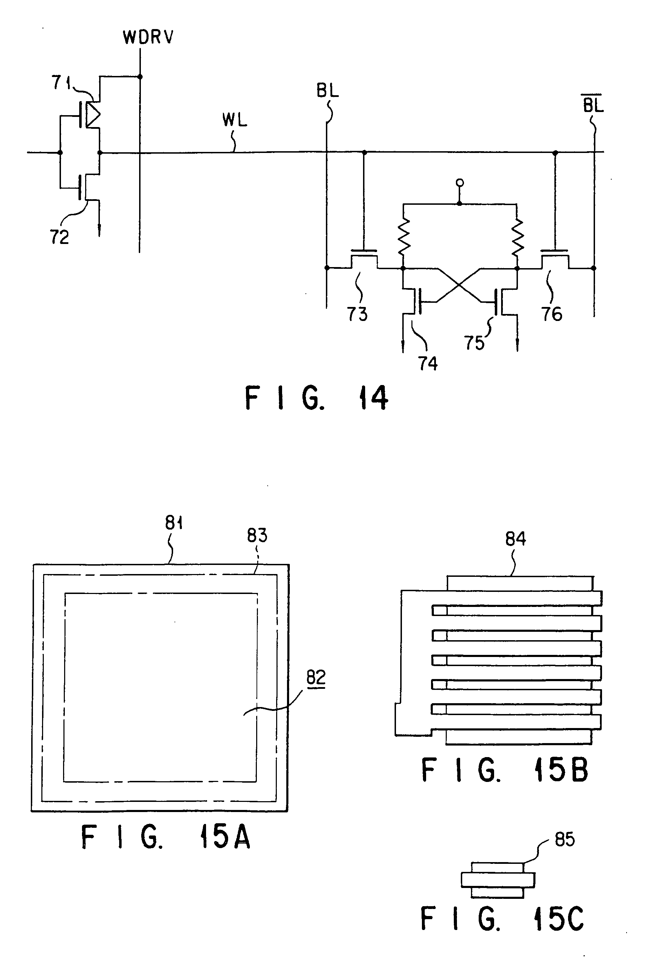

FIG. 14 is a circuit diagram showing a static random-access memory (SRAM) according to the present invention.

As shown in FIG. 14, the SRAM comprises large-sized transistors 71 and 72 and small-sized transistors 73, 74, 75 and 76. The transistors 71 and 72 constitute a peripheral circuit, e.g., a word-line driving circuit, while the transistors 73, 74, 75 and 76 constitute memory cells. The transistors 71 and 72 are isolated from each other by a tapered trench. Similarly, the transistors 73, 74, 75 and 76 are isolated from one another by vertical trenches. The SRAM achieves the same advantages as the DRAM described above.

FIGS. 15A, 15B and 15C show a gate array circuit such as an ASIC (Application Specific IC) according to the present invention.

As illustrated in FIG. 15A, the gate array circuit 81 has a core region 82 and a peripheral circuit 83. The peripheral circuit 83 surrounds the core region 82 which is the central region. As shown in FIG. 15B, the peripheral circuit 83 comprises large-sized transistors 84, which are isolated from one another by tapered trenches. As shown in FIG. 15C, the core region 82 has small-sized transistors 85, which are isolated by vertical trenches. The gate array circuit achieves the same advantages as the DRAM and the SRAM, both described above.

Although illustrative embodiments of the present invention have been described in detail with reference to the accompanying drawings, it is to be understood that the invention is not limited to those precise embodiments and that changes and modifications may be effected therein by those in the art without departing from the scope of the invention as defined in the appended claims.

## Claims

1. A method of manufacturing a semiconductor device comprising forming trenches in a surface of a material **characterized by** comprising the steps of:
forming a mask material pattern (20) on said material (10), the mask material having at least one first window and at least one second window, the or each second window being narrower than the or each first window;
bombarding a surface of said material (10) with ions (15) at a predetermined angular orientation with respect to the material surface such that said ions impinge on said material through said at least one first window (36, 37) but not through said at least one second window (31 to 35) in view of the respective widths of the first and second windows; and
etching said material (10) to form at least one first trench (56, 57) having a substantially tapered sidewall in a region of said at least one first window (36, 37), and to form at least one second trench (51 to 55) having a substantially vertical sidewall in a region of said at least one second window (31 to 35).

2. The method of claim 1, **characterized in that** said step of bombarding comprises bombarding a surface of said material (10) with ions (15) of an etchant thereby implanting said etchant ions into said surface of said material, whereby said etching step proceeds preferentially at said surface of said material because of a chemical effect of said etchant ions on said material and physical damage to said material caused by said step of bombarding.

3. The method of claim 1, **characterized in that** said step of bombarding comprises bombarding a surface of said material (10) with ions (15) of a non-etchant thereby implanting said non-etchant ions into said surface of said material, whereby said etching step proceeds preferentially at said surface of said material because of physical damage to said material caused by said step of bombarding.

4. The method of claim 1, **characterized in that** said step of etching comprises preferentially etching said material (10) in the region of said at least one first window (36, 37).

5. The method of claim 1, **characterized in that** the predetermined angular orientation comprises a predetermined tilt angle (α) with respect to the normal of said surface of said material (10).

6. The method of claim 1, **characterized in that** the predetermined angular orientation comprises a predetermined azimuth angle (*β*) with respect to an azimuth reference direction.

7. The method of claim 1, **characterized in that** said step of etching comprises anisotropic reactive ion etching.

8. The method of claim 7, **characterized in that** said step of bombarding comprises bombarding a surface of said material (10) with ions (15) of an etchant thereby implanting said etchant ions into said surface of said material, whereby said step of anisotropic reactive ion etching proceeds preferentially at said surface of said material because of a chemical effect of said etchant ions on said material and physical damage to said material caused by said step of bombarding.

9. The method of claim 1, and for use in forming a semiconductor memory device on a semiconductor substrate comprising said material, the memory device having an array region (2) and a peripheral circuit region (1), the mask material pattern having respective first windows (36, 37) corresponding to the peripheral circuit region (1) and respective second windows (31 to 35) corresponding to the array region, and wherein the etching step produces respective first trenches having substantially tapered sidewalls in the peripheral circuit region whereby to isolate devices in said peripheral circuit region from one another, and respective second trenches having substantially vertical sidewalls in the array region whereby to isolate devices in said array region from one another.

10. The method of claim 9, **characterized in that** said step of etching comprises anisotropic reactive ion etching.

11. The method according to any one of claims 2, 8 and 10, **characterized in that** said etchant ions comprise Fluorine ions.
